(19) Europäisches Patentamt
European Patent Office
Office européen des brevets

(11) **EP 4 693 354 A1**

(12) **EUROPEAN PATENT APPLICATION**
published in accordance with Art. 153(4) EPC

(43) Date of publication:
**11.02.2026 Bulletin 2026/07**

(21) Application number: **24780832.2**

(22) Date of filing: **29.03.2024**

(51) International Patent Classification (IPC):
*H01F 27/32* $^{(2006.01)}$    *H01F 17/00* $^{(2006.01)}$
*H01F 17/04* $^{(2006.01)}$    *H05K 1/16* $^{(2006.01)}$

(52) Cooperative Patent Classification (CPC):
**H01F 17/00; H01F 17/04; H01F 27/32; H05K 1/16**

(86) International application number:
**PCT/JP2024/013098**

(87) International publication number:
**WO 2024/204737 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.03.2023 JP 2023058832**

(71) Applicant: **Tamura Corporation**
**Tokyo 178-8511 (JP)**

(72) Inventors:
• **SAITO Shoichi**
**Tokyo 178-8511 (JP)**
• **KIYOTA Tatsuya**
**Tokyo 178-8511 (JP)**

• **TANAHASHI Yusuke**
**Iruma-shi, Saitama 358-8501 (JP)**
• **HORI Atsushi**
**Iruma-shi, Saitama 358-8501 (JP)**
• **ENDO Taiki**
**Iruma-shi, Saitama 358-8501 (JP)**
• **AOKI Hirotoshi**
**Sakado-shi, Saitama 350-0214 (JP)**
• **OGAWA Hiroo**
**Sakado-shi, Saitama 350-0214 (JP)**
• **OGI Yusuke**
**Sakado-shi, Saitama 350-0214 (JP)**

(74) Representative: **AWA Sweden AB**
**Matrosgatan 1**
**Box 5117**
**200 71 Malmö (SE)**

(54) **COIL STRUCTURE AND METHOD FOR MANUFACTURING SAME, MULTILAYER SUBSTRATE CIRCUIT USING COIL STRUCTURE, MAGNETIC DEVICE, AND COPPER FOIL WITH RESIN FOR COIL STRUCTURE**

(57) To provide a coil structure, a multilayer circuit board, and a magnetic device which achieve excellent dielectric strength characteristics and low inter-coil capacitance without using glass cloth. The coil structure C has coil patterns 21, 22, and 23, which are plate-like conductors wound on a plane, and an insulating material 1 insulating between the coil patterns 21, 22, and 23. The coil patterns 21, 22, and 23 and the insulating material 1 are alternately laminated. The insulating material 1 is a cured product of an insulating resin composition not containing glass cloth. The multilayer circuit board P includes the coil structure C. The magnetic device D is constituted by laminating the coil structure C and a plurality of the multilayer circuit boards P, and mounting a core 4 thereon.

Fig. 1A

Fig. 1B

Fig. 1C

**Description**

FIELD OF INVENTION

The present disclosure relates to a coil structure used in magnetic devices such as transformers formed by laminating coils, and a method for manufacturing the same, and to a multilayer board circuit using the coil structure. Further, the present disclosure relates to a magnetic device employing these coil structure and multilayer board circuit, and to a resin-coated copper foil for the coil structure.

BACKGROUND

For example, as shown in Patent Document 1, a lamination of printed coils has been known conventionally as a thin transformer used in a switching power supply or the like. The printed coil is configured as follows:

(1) a cloth made of glass fibers (referred to as glass cloth) is used as a base material,
(2) a substrate is formed by impregnating the base material with epoxy resin and curing it,
(3) a spiral planar coil is formed on the front and back surfaces of the substrate by printing or attaching, and
(4) a heat-resistant resin is applied to the front surface of the planar coil to ensure its insulation.

PRIOR ART DOCUMENT

PATENT DOCUMENT

Patent Document 1: JP H09-326316A

PROBLEMS TO BE SOLVED BY INVENTION

However, since the above-mentioned conventional technique uses the substrate (generally referred to as prepreg) formed by impregnating glass cloth with epoxy resin and curing it, there has been a problem that, when the conventional magnetic device is simply made thinner, it cannot be used for large-capacity applications, high-voltage applications, or high-frequency applications due to insufficient insulation between laminated layers and an increase in parasitic capacitance.
The present disclosure has been proposed in order to solve the problems of the conventional technique described above. An object of the present disclosure is to provide a coil structure, a multilayer circuit board, and a magnetic device which achieves excellent dielectric strength characteristics and low inter-coil capacitance without using glass cloth.

SUMMARY OF INVENTION

The coil structure of the present disclosure includes,

a plate-shaped conductor wound on a plane and an insulating material that insulates between the conductors,
in which the conductor and the insulating material being alternately laminated, and
the insulating material is a cured product of an insulating resin composition not containing glass.

In the present disclosure, a configuration as follows can be adopted.

(1) The insulating resin composition has a dielectric strength of 100 kV/mm or higher and a dielectric constant of 4.0 or lower.
(2) The insulating resin composition has adhesiveness.
(3) The insulating resin composition contains an epoxy resin.
(4) The insulating resin composition contains at least one of a polyamide resin, a polyimide resin, and a polyamide-imide resin.
(5) The insulating resin composition contains (a1) liquid epoxy resin, (a2) solid epoxy resin having a softening point of 125 °C or less, (b) an aromatic diamine compound having a benzoate group and having a polymethylene group in its main chain, (c) a solvent-soluble polyimide resin having a Tg of 200 °C or more and a weight-average molecular weight (Mw) of 50,000 or less, and (D) a phenoxy resin having a Tg of 130 °C or more, in which when a total amount of the (a1) liquid epoxy resin, the (a2) solid epoxy resin, and the (b) aromatic diamine compound is 100 parts by weight, a total amount of the (c) solvent-soluble polyimide resin and the (d) phenoxy resin is 15 parts by weight or more and 150 parts by weight or less.

(6) The insulating resin composition is a polyimide derived from (A) an acid dianhydride and (B) a diamine; in which the (A) acid dianhydride includes (A1) an acid anhydride having an ester linkage, in which the (B) diamine contains 0.3 mol or more of (B1) a dimer diamine when the total number of moles of the diamine is 1.0.

(7) The insulating resin composition is a polyimide derived from (A) an acid dianhydride and (B) a diamine, in which the (B) diamine contains (B1) diamine having a fluorene skeleton and a (B2) dimer diamine.

The following configuration is also encompassed in the present disclosure.

(1) A coil structure formed by laminating a resin-coated copper foil in which the insulating resin composition is formed on one surface of a copper foil.

(2) A multilayer circuit board includes the coil structure.

(3) The multilayer circuit board in which a shield layer is provided on an outermost layer or an intermediate layer.

(4) A magnetic device includes the multilayer circuit board and a core attached thereon.

(5) A magnetic device includes a plurality of the multilayer circuit boards laminated, and a core mounted thereon.

(6) A magnetic device includes a plurality of laminations of the coil structure and the multilayer circuit boards, and a core mounted thereon.

(7) The magnetic device in which the operating frequency is 500 kHz to 1 MHz.

(8) A resin-coated copper foil for a coil structure, in which the resin-coated copper foil has an insulating resin composition formed on one surface of a copper foil, a resin layer consisting of the insulating resin composition in a semi-cured state or an insulating resin composition different from the insulating resin composition is formed on the surface of the insulating resin composition of the resin-coated copper foil, and a protective film is laminated on the surface of the semi-cured resin layer.

(9) A resin-coated copper foil for a coil structure, in which a resin layer consisting of an insulating resin composition in a semi-cured state is formed on one surface of a copper foil, and a protective film is laminated on the surface of the semi-cured resin layer.

(10) A method for manufacturing a coil structure, in which the resin-coated copper foil is laminated in a state in which the protective film is removed, such that the semi-cured resin layer and the copper foil are in contact with each other.

According to the present disclosure, since the insulating material between coils is composed of a cured product of the insulating resin composition not containing glass cloth, it becomes possible to provide the coil structure, the multilayer circuit board, and the magnetic device, and the resin-coated copper foil for the coil structure, which enable increased capacity, higher frequency, and thickness reduction by the high dielectric strength and low dielectric constant possessed by the insulating resin composition.

BRIEF DESCRIPTION OF DRAWINGS

FIG. 1 is a diagram illustrating a basic configuration of a magnetic device of the present disclosure, in which 1A a top view of a coil structure, 1B is a perspective view showing a state in which a core is mounted on the coil structure, and 1C is a cross-sectional view taken along line A-A' of 1B.

FIG. 2 is a cross-sectional view illustrating respective steps of a method for manufacturing the magnetic device of FIG. 1.

FIG. 3 is a diagram showing a first embodiment of the magnetic device of the present disclosure, in which 3A is a perspective view, and 3B is a cross-sectional view taken along line B-B' of 3A.

FIG. 4 is a diagram showing a second embodiment of the magnetic device of the present disclosure, in which 4A is a perspective view, and 4B is a cross-sectional view taken along line C-C' of 4A.

FIG. 5 is a diagram showing a third embodiment of the magnetic device of the present disclosure, in which 5A is a perspective view, and 5B is a cross-sectional view taken along line D-D' of 5A.

FIG. 6 is a diagram showing a fourth embodiment of the magnetic device of the present disclosure, in which 6A is a perspective view, and 6B is a cross-sectional view taken along line E-E' of 6A.

FIG. 7 is a diagram showing a fifth embodiment of the magnetic device of the present disclosure, in which 7A is a perspective view, and 7B is a cross-sectional view taken along line B-B' of 7A.

FIG. 8 is a diagram showing a sixth embodiment of the magnetic device of the present disclosure, in which 8A is a perspective view, and 8B is a cross-sectional view taken along line B-B' of 8A.

FIG. 9 is a cross-sectional view schematically showing a method for manufacturing the resin-coated copper foil of the seventh embodiment.
FIG. 10 is a cross-sectional view schematically showing a method for manufacturing the resin-coated copper foil of the eighth embodiment.

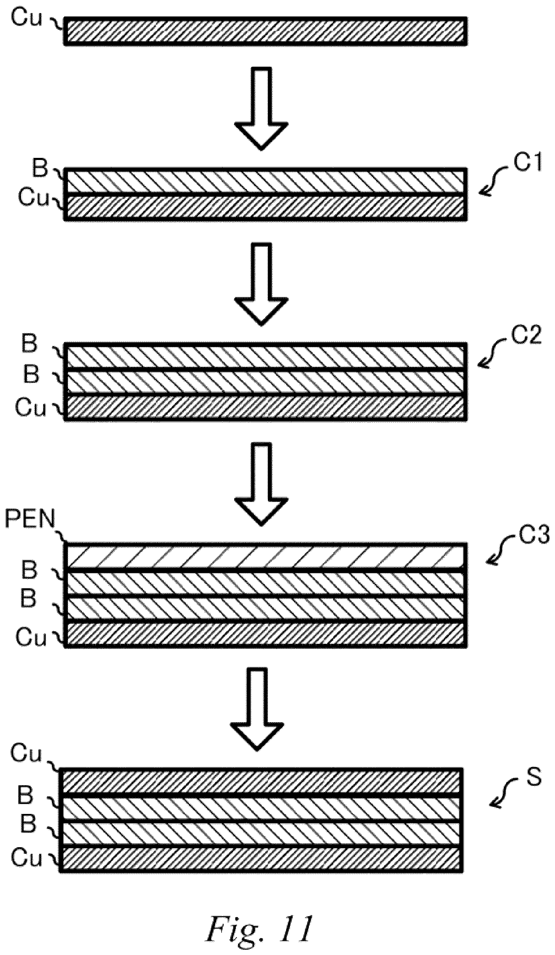

FIG. 11 is a cross-sectional view schematically showing a method for manufacturing the resin-coated copper foil of the ninth embodiment.

## DETAILED DESCRIPTION OF THE EMBODIMENTS

[1. Basic Configuration of Magnetic Device]

(1) Overall Configuration

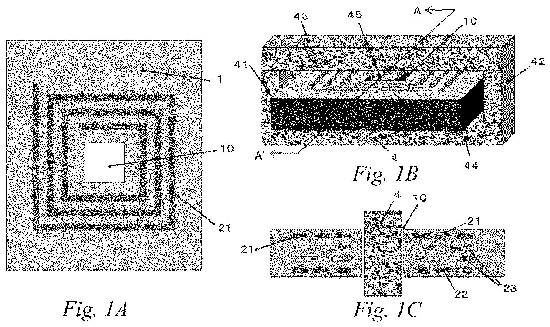

FIG. 1 is a diagram illustrating a basic embodiment of a magnetic device D of the present disclosure, in which 1A is a top view of a coil structure, 1B is a perspective view showing a state in which a core is mounted on the coil structure, and 1C is a cross-sectional view taken along line A-A' of 1B. Since the magnetic device D of the present embodiment is assumed to be a laminated transformer, conductors comprising primary-side coil patterns 21 and 22 and a secondary-side coil pattern 23 are embedded at predetermined intervals inside an insulating material 1 composed of a cured product of an insulating resin composition, and the coil patterns 21, 22, and 23 are insulated from each other by the insulating material 1.
In this embodiment, the insulating material 1 is a rectangular parallelepiped having an opening portion 10 formed at its center, and the primary-side coil patterns 21 and 22 and the secondary-side coil pattern 23 are embedded in a rectangular spiral shape so as to surround the opening 10. The ends of the coil patterns 21, 22, and 23 are connected to external terminals by lead wires (not shown). Around the insulating material 1, a core 4 of the magnetic device D is mounted. In the present embodiment, the core 4 is generally referred to as an E-core, and includes left and right leg portions 41 and 42 disposed around the insulating material 1, upper and lower yoke portions 43 and 44, and a central leg portion 45 that passes through the opening portion 10 and connects the upper and lower yoke portions 43 and 44. The core 4 is constituted of a magnetic material and functions as a magnetic path through which magnetic flux generated by the respective coil patterns 21, 22, and 23 flows. A dust core, a ferrite core, a laminated steel plate, a metal composite core, or the like can be used for the core 4. The metal composite core is a magnetic material formed by kneading magnetic powder and resin, and curing the resin.

(2) Manufacturing Method

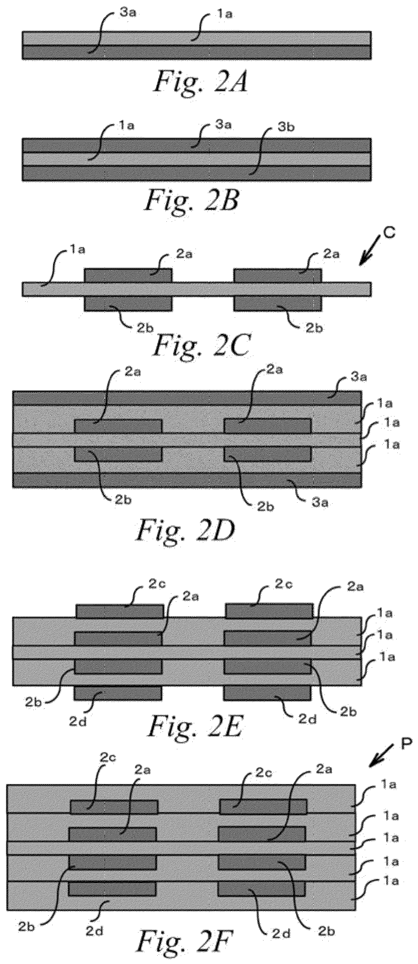

As shown in Fig. 2, the magnetic device D is configured by laminating, in multiple layers, coil structures C in each of which a coil pattern 2a is formed on the surface of an insulating material 1a having a predetermined thickness.

(2-1) Formation of an Insulating Layer on the Surface of a Copper Foil

In manufacturing each coil structure C, first, as illustrated in Fig. 2A an insulating material 1a (hereinafter referred to as varnish), which is dispersed or dissolved in a solvent, is applied to the surface of a copper foil 3a having a predetermined thickness (e.g., 18 $\mu$m, 25 $\mu$m, or 35 $\mu$m). In this case, the coating thickness of the insulating material 1a is adjusted so that the thickness of the insulating material 1a after the solvent has evaporated becomes a desired value (for example, 25 $\mu$m). Thereafter, the solvent is evaporated by performing preliminary drying at about 100 to 120°C. In this state, the insulating resin composition is not completely cured and the surface of the resin has adhesiveness, therefore, the surface of the insulating material 1a is covered with a polypropylene protective film during storage or transportation.

(2-2) Thermal Curing of Insulating Material

After the insulating material 1a is laminated on one surface of the copper foil 3a, as shown in Fig. 2B, a new copper foil 3b is laminated on the opposite surface of the insulating material 1a of the copper foil 3a (the surface on which the insulating material 1a is exposed) . In this case, the new copper foil 3b is brought into close contact with and fixed to the surface of the insulating material 1a by the adhesiveness of the insulating material 1a. In this state, the insulating material 1a having copper foils 3a and 3b laminated on both surfaces is set in a vacuum press, and by subjecting it to heat and pressure molding, for example, at 180°C for 120 minutes, 1 MPa, and a vacuum degree of 5 torr, the insulating material 1a is thermally cured.
In the coil structure C in which only a single layer of a coil pattern is used, for example, in a coil structure such as a coil for non-contact power transmission or an antenna of an RF tag, an insulating material 1a is applied onto one surface of the copper foil 3a and, after preliminary drying, is thermally cured as it is.

(2-3) Formation of Coil Pattern

For the laminate of the cured insulating material 1a and the copper foils 3a and 3b, which has been taken out from the vacuum press, coil patterns 2a and 2b are formed by etching the copper foils 3a and 3b on both surfaces thereof. As an etching process, known techniques such as methods used at the time of producing conventional coil structures using the glass cloth as a base material can be appropriately adopted. By carrying out the etching process, as shown in Fig. 2C, unnecessary portions of the copper foils 3a and 3b are removed, and the coil structure C in which coil patterns 2a and 2b are formed on both surfaces of the cured insulating material 1a is obtained.

(2-4) Multilayering of Coil Pattern and Insulating Material

In order to obtain a multilayer circuit board P by laminating the coil structures C configured as described above, the following procedure is employed. That is, after coil patterns 2a and 2b are formed on both surfaces in the step (2-3), two new copper foils 3a with the insulating material 1a shown in Fig. 2A are prepared, and the surfaces thereof from which the protective films have been peeled are superposed on the coil pattern surfaces 2a and 2b shown in Fig. 2C. In this way, after the three layers of the insulating material 1a laminated as shown in Fig. 2D are obtained, the three layers of the insulating material 1a is, similarly to the step (2-2), set in a vacuum press and, by performing heat and pressure molding, the newly laminated insulating material 1a is thermally cured.

It should be noted that, in Fig. 2, since the insulating material 1a and the copper foils 3a and 3b are schematically illustrated, gaps appear between the coil patterns 2a and 2b formed by etching; however, because the preliminarily dried insulating material 1a has flexibility, the gaps are filled with the insulating material 1a when pressure molding is performed with the vacuum press.

The copper foil 3a with insulating material 1a shown in FIG. 2A is a copper foil with the insulating resin composition formed on one surface thereof, and is called a resin-coated copper foil. In this embodiment, a semi-cured insulating resin composition layer (resin layer) is formed on a copper foil, and there are no particular limitations on the thickness of the copper foil and the resin layer. For example, in the case where the copper foil thickness is 35 $\mu$m, the thickness of the resin layer is preferably 5 $\mu$m or more and 200 $\mu$m or less, and more preferably 10 $\mu$m or more and 150 $\mu$m or less. If the thickness is not more than the above upper limit, the thickness of the layer structure can be made thinner. If the thickness is not less than the above lower limit, the dielectric strength can be improved. The resin layer herein may also be laminated in a plurality of layers, and, for example, by previously forming a resin layer on a copper foil, curing it, and then again forming a resin layer on the cured surface, the dielectric strength can be improved. It should be noted that the resin layers laminated in multiple layers may be different insulating resin compositions.

By laminating a protective film on the semi-cured resin surface of the resin-coated copper foil, adhesion of dust and the like to the surface of the resin layer can be prevented, and the handling property can be improved.

Examples of materials used for the protective film include polyolefins such as polyethylene, polypropylene, and polyvinyl chloride; polyesters such as PET and PEN; polycarbonate; and polyimide.

(2-5) Formation of Coil Pattern

After the newly laminated insulating material 1a is cured, the copper foils 3a exposed on both surfaces thereof are subjected to an etching process, thereby forming coil patterns 2c and 2d as shown in Fig. 2E.

(2-6) Production of Multilayer Circuit Board

Hereinafter, by repeating the above-mentioned steps, inside a block-shaped insulating material 1, in which the insulating materials 1a constituting each coil structure are laminated and integrated, the primary-side coil patterns 21 and 22 and the secondary-side coil pattern 23, which are constituted by the coil patterns 2a to 2d constituting each coil structure, are embedded while maintaining predetermined intervals, and as a result, as shown in Fig. 2f, the multilayer circuit board P formed in the shape of one block as a whole, is constituted. With respect to the multilayer circuit board P, by mounting the core 4, the magnetic device D of the present embodiment can be obtained. In the case where the outermost coil pattern of the multilayer circuit board P is covered with an insulating material, after forming the outermost coil pattern in step (2-5), the insulating material 1a is applied to its surface, and preliminary drying and heat curing are performed.

(3) Insulating Material

As the insulating material in the above embodiment, an insulating resin composition not containing glass cloth is used. That is, since the prepreg is obtained by impregnating glass cloth with a resin, it is inevitable that the dielectric strength characteristics deteriorate due to the physical properties of the glass cloth and that the capacitance between coil patterns increases. Therefore, in the present embodiment, as the insulating material, a cured product of an insulating resin composition free of glass cloth inside is used. In particular, it is preferable that the insulating resin composition free of glass cloth has a dielectric strength of 100 kV/mm or higher and a dielectric constant of 4.0 or lower preferably, the insulating resin composition has adhesiveness before thermal curing.

(3-1) Specific Examples of Insulating Resin Composition

As the insulating resin composition constituting the insulating material, it is preferable to use one having high dielectric strength characteristics and low capacitance when coil patterns are formed on both surfaces of the insulating material to constitute a magnetic device, and, for example, it contains at least one thermosetting resin selected from the group consisting of epoxy resins, phenolic resins, cyanate resins, melamine resins, amino resins, imide resins, and amide-imide resins. In the case where the thermosetting resin contains an epoxy resin, the epoxy resin contains at least one resin selected from the group consisting of multifunctional epoxy resins, bisphenol-type epoxy resins, novolac-type epoxy resins, and biphenyl-type epoxy resins.

The insulating resin composition may further contain at least one component selected from the group consisting of fillers, curing agents, and curing accelerators. The filler contains at least one selected from the group consisting of silica, aluminum hydroxide, magnesium hydroxide, calcium carbonate, talc, and alumina. The curing agent contains at least one selected from phenolic curing agents and dicyandiamide curing agents. The curing accelerator contains at least one selected from the group consisting of imidazoles, phenolic compounds, amines, and organic phosphines. For example, polyimide resins and epoxy resins can be used.

The insulating resin composition may further contain, if necessary, inorganic fillers, flame retardants, and additives. The inorganic filler, for the purpose of improving the heat resistance, flame retardancy, lower expansion coefficient, thermal conductivity, and the like of the cured product of the insulating resin composition, can use various kinds including known ones. Specific examples of the inorganic filler include silica, alumina, talc, aluminum hydroxide, magnesium hydroxide, titanium oxide, mica, aluminum borate, barium sulfate, and calcium carbonate." Among these inorganic fillers, only one kind may be used, or two or more kinds may be used together. Also, the inorganic filler may be used as it is, or depending on the purpose, surface-treated with an epoxy-silane type or an amino-silane type silane coupling agent may be used.

Examples of the flame retardant include phosphorus-based flame retardants and halogen-based flame retardants. Specific examples of phosphorus-based flame retardants include phosphate esters such as condensed phosphate esters and cyclic phosphate esters, phosphazene compounds such as cyclic phosphazene compounds, phosphinate-based flame retardants such as phosphinic acid metal salts including aluminum dialkylphosphinates. Examples of halogen-based flame retardants include bromine-based flame retardants. Also, from the viewpoint of being halogen-free, phosphorus-based flame retardants are preferably used. As the flame retardant, the exemplified flame retardants may be used individually, or two or more of them may be used in combination.

Examples of additives include defoaming agents such as silicone-based defoaming agents and acrylic ester-based defoaming agents; heat stabilizers; antistatic agents; ultraviolet absorbers; dyes and pigments; lubricants; and dispersants such as wetting dispersants. Among these additives, only one kind may be used, or two or more kinds may be used together.

(3-2) Preferred Insulating Resin Composition

In the present embodiment, as the insulating material, resin compositions shown as Materials A to Materials D below are preferable.

(A) Material A, Material D

(a1) liquid epoxy resin,
(a2) solid epoxy resin having a softening point of 125 °C or less,
(b) an aromatic diamine compound having a benzoate group and having a polymethylene group in its main chain,
(c) a solvent-soluble polyimide resin having a Tg of 200 °C or more and a wight-average molecular weight (Mw) of 50,000 or less,
(d) a phenoxy resin having a Tg of 130 °C or more,

The insulating resin composition, in which when the total amount of the (a1) liquid epoxy resin, the (a2) solid epoxy resin, and the (b) aromatic diamine compound is 100 parts by weight, the total amount of the (c) solvent-soluble polyimide resin and the (d) phenoxy resin is 15 parts by weight or more and 150 parts by weight or less.

Material A has a certain degree of flexibility and can be formed into a thin insulating layer, and has durability and excellent processing properties as well as high insulating properties, thereby providing reduced capacitance between coil patterns and excellent dielectric strength characteristics.

(B) Material B

A polyimide derived from (A) an acid dianhydride and (B) a diamine;

in which the (A) acid dianhydride includes (A1) an acid anhydride having an ester linkage,
the polyimide has the (B) diamine, in which, when the total number of moles of all diamines is taken as 1.0, at least 0.3 moles are (B1) a dimer diamine."

Although general polyimides have excellent heat resistance and mechanical properties, they have a high dielectric constant, resulting in a large capacitance. If the dielectric constant is high, the capacitance will be large, and when used for high-speed communication (high frequency), it will generate heat and cause malfunctions. Another problem is that polyimides have high water absorption. Material B has a dimer skeleton and an ester skeleton, and therefore exhibits low dielectric constant and low water absorption.

(C) Material C

A polyimide derived from (A) an acid dianhydride and (B) a diamine;
in which the polyimide comprises (B1) a diamine having a fluorene skeleton and (B2) a dimer diamine.

According to Material C, introduction of the fluorene skeleton and the dimer skeleton into the diamine component reduces the concentration of imide groups and reduces the overall molecular polarity, thereby enabling a lower dielectric constant. In addition, it exhibits excellent mechanical strength, and high values can be obtained for both relative dielectric constant and dielectric loss tangent.

(4) Coil Structure

The magnetic device of the present embodiment is, as shown in FIG. 1, a plurality of coil patterns 21, 22, and 23 are formed inside the insulating material 1, and the core 4 is mounted thereto. However, the present disclosure is not limited to the magnetic device having the core. For example, the present disclosure also includes a coil structure in which a plate-shaped conductor wound on a plane and an insulating material that insulates between the conductors are provided, the conductors and the insulating material being alternately laminated, and which does not have a core. Further, a multilayer circuit board in which a plurality of such coil structures are laminated without using a core is also included. Although the operating frequency of the magnetic device is preferably in a range of 500 kHz to 1 MHz, which is suitable, for example, for a power supply transformer, the present embodiment can also be applied to a coil structure used in a circuit of a higher frequency band.

As the material of the coil, in addition to a coil pattern obtained by etching a copper foil, it is also possible to use a copper plate having a certain thickness, or a rod-shaped or wire-shaped conductor used as a bus bar. In the case of a conductor having such rigidity, it is also possible to form a coil structure by applying an insulating material made of an insulating resin composition around the conductor, or by covering it with an insulating tape or sheet, and then thermally curing it.

(5) Multilayer Circuit Board

By laminating a plurality of the above coil structures or by combining the above coil structure with another circuit board, a multilayer circuit board is constituted. In the multilayer circuit board, a structure in which substrates in which coil patterns of a coil structure are formed as a part of a circuit board including wiring patterns are laminated in multiple layers is also included. Furthermore, the multilayer circuit board can be formed not only by laminating the same coil structure, but also by laminating a plurality of different types of coil structures described in the embodiments of this specification, or by laminating a combination of a coil structure using a conventional glass cloth and a coil structure not containing the glass cloth according to the present embodiment.

[2. First Embodiment]

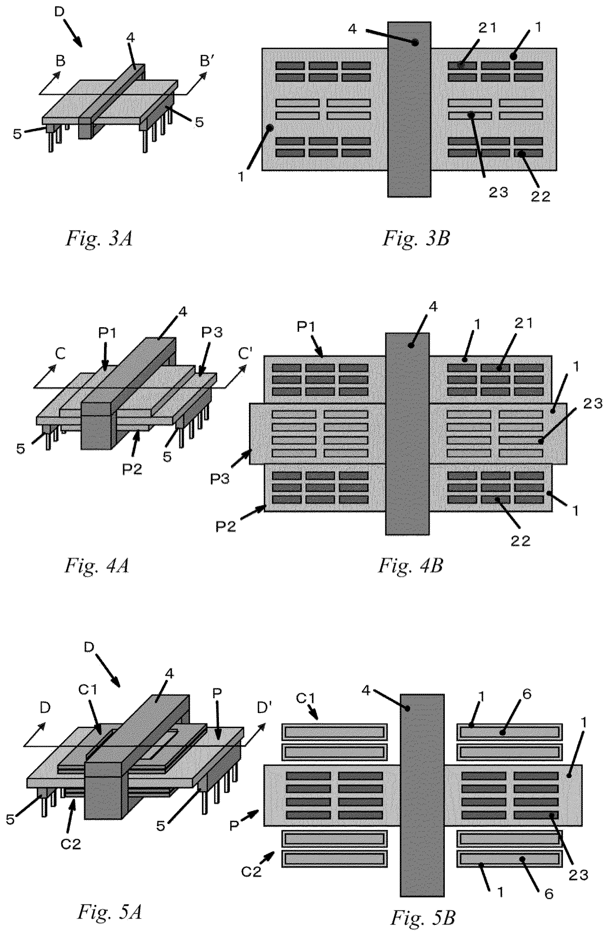

As shown in FIG. 3, the magnetic device of the first embodiment uses a multilayer circuit board formed by laminating coil structures, and the basic configuration is the same as that of Fig. 1. In the present embodiment, inside the insulating material 1, the primary-side coil patterns 21 and 22 and the secondary-side coil pattern 23 are embedded at a predetermined interval while maintaining insulation. At both ends of the insulating material 1, connectors 5 for connecting the primary-side coil patterns 21 and 22 and the secondary-side coil pattern 23 to an external device are provided.

Since the magnetic device of the present embodiment incorporates a plurality of coil patterns inside a single multilayer circuit board, it has a configuration specialized for miniaturization and thinning, and, for example, it is suitable for applications of about 30 W or less in power capacity, such as

> power semiconductor drive power supplies,
> controls for home appliances and air conditioners, and
> power adapters.

Further, there is also an effect that, by making it a multilayer board, peripheral circuit components can be integrated.

[2. Second Embodiment]

As shown in FIG. 4, the magnetic device of the second embodiment is a lamination of multilayer circuit boards P1, P2, and P3 including coil structures. That is, in the present embodiment, the primary coil patterns 21 and 22 and the secondary coil pattern 23 are constituted by separate multilayer circuit boards P1, P2, and P3, respectively, and by laminating these multilayer circuit boards P1, P2, and P3, one magnetic device D is constituted as a whole.

By stacking a plurality of multilayer circuit boards P1, P2, and P3 and lowering the current density, the magnetic device of the present embodiment has an effect that the power can be improved. Further, when the number of coil patterns increases, each time the coil structures are laminated, the central insulating material 1 is repeatedly subjected to thermal curing treatment. In the present embodiment, in a case where there is a risk of thermal deterioration due to repeated heating, by separately manufacturing the individual multilayer circuit boards P1, P2, and P3, the number of thermal curing treatments applied to the insulating material 1 can be reduced, so that the influence of thermal deterioration can be eliminated. Further, in a case where a change in the number of turns of the coil is required according to the rating, capacity, or the like of the magnetic device D, there is also an advantage that it can be dealt with only by changing the multilayer circuit boards P1, P2, and P3 to be laminated.

The magnetic device of the present embodiment is suitable, for example, for applications of about 300 W or less in power capacity, such as

> power supplies for industrial equipment,
> power supplies for actuators,
> servo amplifier power supplies,
> battery chargers, and
> LED lighting power supplies.

[4. Third Embodiment]

As shown in FIG. 5, the magnetic device of the third embodiment is a lamination of a multilayer circuit board P including a secondary-side coil pattern 23 and primary-side coil structures C1 and C2, in which copper plates 6 punched into a quadrangular shape are superposed and connected in a coil form. Around the copper plates 6 of the primary-side coil structures C1 and C2, the insulating material 1 of a thermosetting composition similar to the insulating material 1 of the multilayer circuit board P is formed. As a method of forming the insulating material 1 on the surface of the copper plate 6, coating, covering with a tape or a sheet, or the like can be used. Further, it is also possible to set the copper plate 6 formed into a coil shape in a mold, inject the insulating material 1, preliminarily dry it, and then thermally cure it with the vacuum press or the like.

In the present embodiment, by using, as the secondary-side coil structures C1 and C2, a conductor made of copper plates 6 having a larger cross-sectional area compared with a coil pattern by etching, it becomes possible to further lower the current density, and there is an effect that the power can be improved. Further, by combining the multilayer circuit board P using the copper foil 3 and coil structures C1 and C2 using copper plates 6, for example, when the magnetic device D is used as a power transformer, according to the required power capacity, input/output voltage, or the like, it is possible to easily change the conductor cross-sectional area of the coil structures C1 and C2 to be combined and the thickness of the insulating material, and versatility is excellent.

The magnetic device of the present embodiment is suitable for applications of about 1kW or less in power capacity, such as

power supplies for industrial equipment,
power supplies for actuators,
servo amplifier power supplies,
battery chargers, and
power supplies for servers.

[5. Fourth Embodiment]

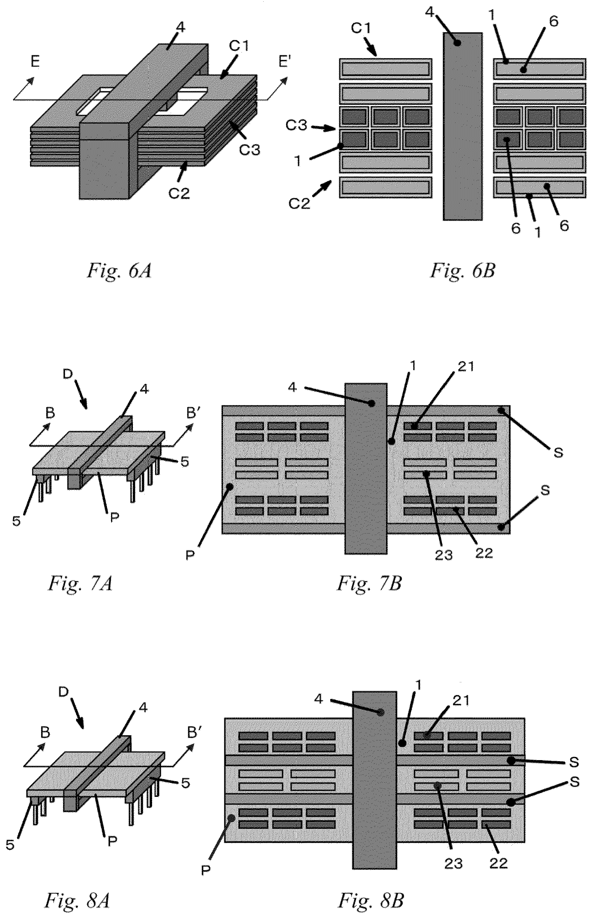

As shown in FIG. 6, the fourth embodiment uses, as the primary coil, instead of the multilayer circuit board P of the third embodiment, a coil structure C3 of a conductor made of copper plates 6. That is, with respect to the secondary coil structures C1 and C2, same as in the third embodiment, square copper plates 6 punched into a coil shape are used, and with respect to the primary-side coil structure C3, a rectangular wire is used as the copper plate 6. With respect to the insulating material 1 formed around the copper plate 6, an insulating material similar to that formed around the copper plate 6 of the third embodiment can be used. In this case, with respect to the secondary-side coil structures C1 and C2 and the primary-side coil structure C3, the cross-sectional shape, cross-sectional area, and number of turns of the copper plate 6 serving as the conductor can be changed in accordance with the required characteristics of the magnetic device.

In the present embodiment, by using, for all of the coil structures C1, C2, and C3, the conductor made of copper plates 6, the current density can be further lowered, and the power can be improved. Therefore, it is suitable, for example, for applications of about 1kW or less in power capacity, such as

power supplies for industrial equipment,
battery chargers, and
power supplies for servers.

[6. Fifth Embodiment]

As shown in FIG. 7, the magnetic device of the fifth embodiment provides a shield layer S on the outermost layer of the multilayer circuit board P. As the shield layer S, it is possible to use

a sheet material in which soft magnetic powder is
dispersed in resin,
a sheet material in which carbon powder is dispersed in resin, and
a sheet material in which a metal layer is coated with resin.

According to the fifth embodiment, it is possible to suppress leakage flux generated from the coil from leaking out from the outermost layer.

[7. Sixth Embodiment]

As shown in FIG. 8, the magnetic device of the sixth embodiment provides a shield layer S on the intermediate layer of the multilayer circuit board P. As the shield layer S, it is possible to use that described in the fifth embodiment.

According to the sixth embodiment, it is possible to adjust the coupling degree of the primary-side coil and the secondary-side coil.

[Examples]

Regarding Examples 1 to 6 of the present disclosure, in comparison with Comparative Examples 1 and 2 using prepreg as the insulating material, effects with respect to each item of capacitance (1 MHz), dielectric strength, low leakage, and total thickness were confirmed.

(1) Comparative Example 1

As the insulating material, a coil structure was made by laminating three layers of a 100-$\mu$m-thick prepreg (glass cloth base epoxy resin substrate R-1766/R-1661 sold by Panasonic Industry Co., Ltd.) and providing on both surfaces coil patterns of 25-$\mu$m thickness.

Dielectric constant of the insulating material (1 MHz): 4.7
Dielectric strength: 64 kV/mm

Thickness of insulating material: 100 μm × 3 = 300 μm
Thickness of coil pattern: 25 μm × 2 = 50 μm
Total thickness: 350 μm
Distance between patterns: 300 μm

(2) Comparative Example 2

As the insulating material, a coil structure was made by using one layer of a 100-μm-thick prepreg (glass cloth base epoxy resin substrate R-1766/R-1661 sold by Panasonic Industry Co., Ltd.) same as the Comparative Example 1 and providing on both surfaces coil patterns of 25-μm thickness.

Dielectric constant of the insulating material (1 MHz): 4.7
Dielectric strength: 64 kV/mm
Thickness of insulating material: 100 μm × 1 = 100 μm
Thickness of coil pattern: 25 μm × 2 = 50 μm
Total thickness: 150 μm
Distance between patterns: 100 μm

(3) Example 1 Polyimide + Material A

As the insulating material, one-layer coil structure in which a coil pattern was formed on a 25-μm-thick polyimide film-based flexible substrate material (single-sided copper-clad laminate R-F770 sold by Panasonic Industry Co., Ltd.), and one-layer coil structure in which a coil pattern was formed on one side of the material A described below were laminated so that the coil patterns were on the outside, respectively.

(3-1) Polyimide (R-F770)

Dielectric constant of the insulating material (1 MHz): 3.2
Dielectric strength: 276kV/mm
Thickness of insulating material: 25 μm
Thickness of coil pattern: 25 μm

(3-2) Specific Example of the Material A

A mixture consisting of 98 parts by weight of bisphenol A type epoxy resin Epiklon 850-S (manufactured by DIC, epoxy equivalent 188), 147 parts by weight of dicyclopentadiene type epoxy resin HP-7200H (manufactured by DIC, epoxy equivalent 283, softening point 83 °C), 126 parts by weight of elastomer 250P (polytetramethylene oxide-di-p-aminobenzoate, manufactured by Ihara Chemical, melting point 60 °C), 100 parts by weight of soluble polyimide resin Q-VR-X0163 (manufactured by PI R&D Institute, Tg 246 °C, resin solid content 20 wt%), 303 parts by weight of phenoxy resin ERF-001M30 (manufactured by Nippon Steel Chemical, Tg 146 °C, resin solid content 30 wt%), and 18 parts by weight of HCA was prepared, and a resin varnish having a resin solid content of 40 wt% was adjusted. The resin varnish thus adjusted was applied to a copper foil forming a coil pattern, then prebaked at 120 °C for 10 minutes, and thermally cured at 180 °C for 120 minutes, thereby obtaining material A1, which is an epoxy resin cured product.

Dielectric constant of the insulating material (1 MHz): 3.1
Dielectric strength: 229kV/mm
Thickness of insulating material: 25 μm
Thickness of coil pattern: 25 μm

(3-3) (Polyimide + Material A) Total thickness and distance value between patterns

Total thickness: 100 μm
Distance between patterns: 50 μm

(4) Example 2 Polyimide + Material B

A one-layer coil structure in which a coil pattern was formed on a single-sided copper-clad laminate (R-F770) using the polyimide of Example 1, and a one-layer coil structure in which a coil pattern was formed on one side of the material B described below were laminated so that the coil patterns were on the outside, respectively.

(4-1) Polyimide

Same as the Example 1

(4-2) Specific Example of the Material B

Into a 1-L four-neck separable flask equipped with a stirrer, a reflux condenser, and a thermometer were charged 0.5 g of 4,4'-oxydianiline, 4 g of dimer diamine (Croda Japan, PRIAMINE 1075), 6.2 g of 2,2',3,3',5,5'-hexamethyl[1,1'-biphenyl]-4,4'-diyl= bis(1,3-dioxo-1,3-dihydro-2-benzofuran-5-carboxylat e), and 32 g of N-methyl-2-pyrrolidone, and while nitrogen was blown into the reaction vessel at 0.1 mL/sec, the mixture was stirred and heated at 50 °C for about 3.5 hours, and after confirming salt dissolution, further stirred at room temperature for 24 hours to synthesize polyamic acid, which is a precursor of polyimide. This polyamic acid itself is a solution, and can be used as a varnish for coating on copper foil as it is.

The polyamic acid synthesized in this manner was coated on a copper foil for forming a coil pattern, then prebaked at 120 °C for 10 minutes, and thermally cured at 150 °C for 60 minutes, and further thermally cured at 180 °C for 30 minutes, whereby the polyamic acid underwent ring-closing polymerization to obtain Material B, which is a polyimide resin.

Dielectric constant of the insulating material (1 MHz): 2.65
Dielectric strength: 308kV/mm
Thickness of insulating material: 25 $\mu$m
Thickness of coil pattern: 25 $\mu$m

(4-3) (Polyimide + Material B) Total thickness and distance between patterns

Same as the Example 1

(5) Example 3 Polyimide + Material C

A one-layer coil structure in which a coil pattern was formed on a single-sided copper-clad laminate (R-F770) using the polyimide of Example 1, and a one-layer coil structure in which a coil pattern was formed on one side of Material C described below, were laminated so that the coil patterns were positioned on the outside.

(5-1) Polyimide (R-F770)

Same as the Example 1

(5-2) Material C

Into a 1-L four-neck separable flask equipped with a stirrer, a reflux condenser, and a thermometer were charged 8.7 g of 9,9-bis(4-aminophenyl)fluorene, 13.35 g of dimer diamine (Croda Japan, PRIAMINE 1075), 10.9 g of pyromellitic dianhydride, and 76.9 g of N-methyl-2-pyrrolidone, and while nitrogen was blown into the reaction vessel at 0.1 mL/sec, the mixture was stirred and heated at 50 °C for about 3.5 hours, and after confirming salt dissolution, further stirred at room temperature for 24 hours to synthesize polyamic acid, which is a precursor of polyimide. Same as the material B, this polyamic acid itself is a solution, and can be used as a varnish for coating on copper foil as it is. The polyamic acid thus synthesized was applied to a copper foil for forming a coil pattern, then prebaked at 120 °C for 10 minutes, thermally cured at 150 °C for 60 minutes, and further thermally cured at 180 °C for 30 minutes, whereby the polyamic acid underwent ring-closing polymerization to obtain Material C, which is a polyimide resin.

Dielectric constant of the insulating material (1 MHz): 2.7
Dielectric strength: 333kV/mm
Thickness of insulating material: 25 $\mu$m

Thickness of coil pattern: 25 μm

(5-3) (Polyimide + Material A) Total thickness and distance value between patterns

Same as the Example 1

(6) Example 4 Material A alone

As the insulating material, a coil structure was made in which Material A, having coil patterns formed on both surfaces, was used alone. The thickness of the insulating material of Material A was set to 50 μm so as to be equal to the total thickness of the polyimide of Example 1 and Material A.

(7) Example 5 Material B alone

As the insulating material, a coil structure was made in which Material B, having coil patterns formed on both surfaces, was used alone. The thickness of the insulating material of Material B was set to 50 μm so as to be equal to the total thickness of the polyimide of Example 1 and Material A.

(8) Example 6 Material C alone

As the insulating material, a coil structure was made in which Material C, having coil patterns formed on both surfaces, was used alone. The thickness of the insulating material of Material C was set to 50 μm so as to be equal to the total thickness of the polyimide of Example 1 and Material A.

(9) Example 7

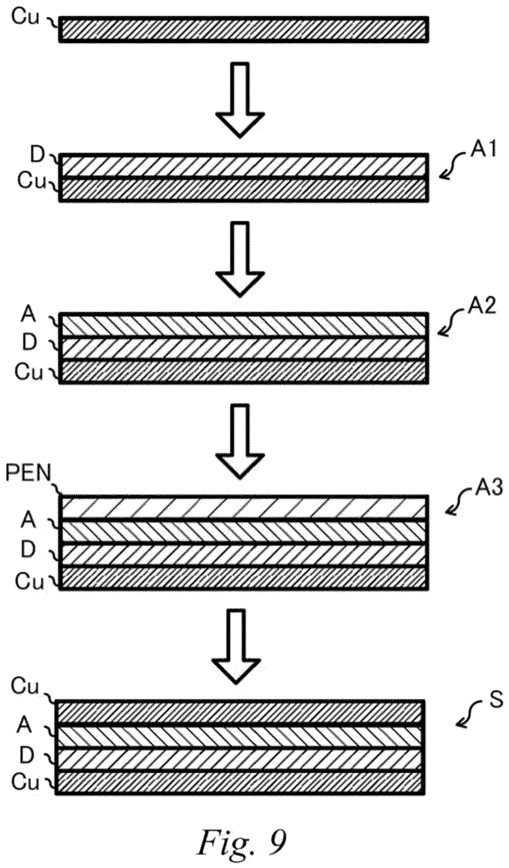

Fig. 9 schematically shows one example of a method of manufacturing a resin-coated copper foil of this embodiment.

(1) A resin varnish of Material D was applied onto an 18-μm copper foil Cu with a die coater, dried at a temperature of 190 °C, and a resin-coated copper foil A1 having a fully cured resin layer with a resin thickness of 51 μm was manufactured.
(2) Subsequently, a resin varnish of Material A was applied onto the cured resin film of the above resin-coated copper foil, dried at a temperature of 120 °C, and a resin-coated copper foil A2 was manufactured in which a semi-cured resin layer with a thickness of 51 μm was further laminated The volatile component was adjusted to 0.5 wt%.
(3) Thereafter, a PEN (polyethylene naphthalate) film was laminated as a protective film on the above semi-cured resin layer to manufacture a resin-coated copper foil A3 for multilayering.
(4) In the evaluation, PEN, which is the protective film, was removed from the resin-coated copper foil A3, a copper foil Cu for conduction was laminated on the surface of the semi-cured resin Material A, and an evaluation sample S was prepared. This evaluation sample corresponds to a single-layer portion of the coil structure of this embodiment in which conductors and insulating materials are alternately laminated, and each electrical property obtained with this sample corresponds to the electrical properties of the coil structure.
(5) Specific Example of the Material D

A mixture consisting of 98 parts by weight of bisphenol A type epoxy resin Epiklon 850-S (manufactured by DIC, epoxy equivalent 188), 147 parts by weight of dicyclopentadiene type epoxy resin HP-7200H (manufactured by DIC, epoxy equivalent 283, softening point 83 °C), 126 parts by weight of elastomer 250P (polytetramethylene oxide-di-p-aminobenzoate, manufactured by Ihara Chemical, melting point 60 °C), 100 parts by weight of soluble polyimide resin Q-VR-X0163 (manufactured by PI R&D Institute, Tg 246 °C, resin solid content 20 wt%), 303 parts by weight of phenoxy resin ERF-001M30 (manufactured by Nippon Steel Chemical, Tg 146 °C, resin solid content 30 wt%), and 18 parts by weight of HCA and 10 parts by weight of 2E4MZ (manufactured by Shikoku Kasei Kogyo Co., Ltd.) was prepared, and a resin varnish having a resin solid content of 40 wt% was adjusted.

Dielectric constant of the insulating material (1 MHz): 3.1
Dielectric strength: 229kV/mm
Thickness of insulating material: 25 μm

(10) Example 8

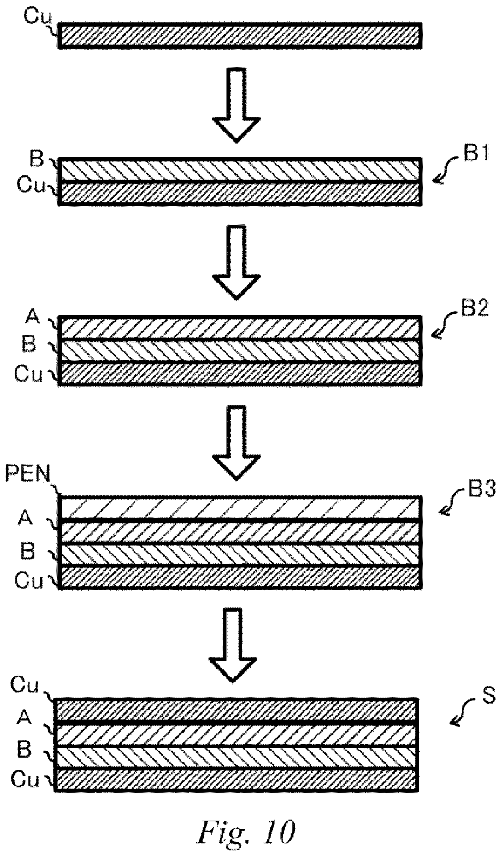

Fig. 10 schematically shows one example of a method of manufacturing a resin-coated copper foil of this embodiment.

(1) A resin varnish of Material B was applied onto an 18-$\mu$m copper foil with a die coater, dried at a temperature of 190 °C, and a resin-coated copper foil B1 having a fully cured resin layer with a resin thickness of 51 $\mu$m was manufactured.
(2) Subsequently, a resin varnish of Material A was applied onto the cured resin film of the above resin-coated copper foil, dried at a temperature of 120 °C, and a resin-coated copper foil B2 was manufactured in which a semi-cured resin layer with a thickness of 51 $\mu$m was further laminated The volatile component was adjusted to 0.5 wt%.
(3) Thereafter, a PEN (polyethylene naphthalate) film was laminated as a protective film on the above semi-cured resin layer to manufacture a resin-coated copper foil B3 for multilayering.
(4) In the evaluation, PEN, which is the protective film, was removed from the resin-coated copper foil B3, a copper foil Cu for conduction was laminated on the surface of the semi-cured resin Material A, and an evaluation sample S was prepared.

(11) Example 9

(1) A resin varnish of Material B was applied onto an 18-$\mu$m copper foil with a die coater, dried at a temperature of 190 °C, and a resin-coated copper foil C1 having a fully cured resin layer with a resin thickness of 51 $\mu$m was manufactured.
(2) Subsequently, a resin varnish of Material B was applied onto the cured resin film of the above resin-coated copper foil, dried at a temperature of 120 °C, and a resin-coated copper foil C2 was manufactured in which a semi-cured resin layer with a thickness of 51 $\mu$m was further laminated The volatile component was adjusted to 0.5 wt%.
(3) Thereafter, a PEN (polyethylene naphthalate) film was laminated as a protective film on the above semi-cured resin layer to manufacture a resin-coated copper foil C3 for multilayering.
(4) In the evaluation, PEN, which is the protective film, was removed from the resin-coated copper foil C3, a copper foil Cu for conduction was laminated on the surface of the semi-cured resin Material B, and an evaluation sample S was prepared.

(12) Evaluation Method

The evaluation concerning the Comparative Examples and the Examples was carried out by the following method.

(12-1) Capacitance

The calculation of capacitance was carried out from the following formula.

Capacitance C = (dielectric constant of the insulating material $\times$ dielectric constant of vacuum $\times$ pattern area) / distance between patterns

Examples 1 to 3, as two capacitors having two kinds of dielectrics, calculated the capacitance by the above formula and the final capacitance was calculated by the following formula which obtains the combined capacitance in the case where the two capacitors are connected in series.

$$1/C = 1/C1 + 1/C2$$

(12-2) Dielectric Strength

Based on the value of dielectric strength per thickness of the insulating material, it was converted to the distance between patterns and calculated.

(12-3) Evaluation of Low Leakage (magnetic flux leakage)

Since the magnetic flux leakage from between the patterns decreases in inverse proportion to the distance between patterns, the evaluation was carried out based on the distance between patterns.

When exceeding 100 μm: unacceptable
When in the range of 100 to 50 μm: acceptable
When 50 μm or less: excellent

(12-4) Total Thickness

It was calculated by adding the thickness of the insulating material between patterns and the thickness of the patterns between which the insulating material is interposed.

(12-5) Measurement Method

(1) Dielectric constant (1 MHz)

Shape of evaluation sample: 20 mm × 20 mm × 200 μm thick
Manufacturer name: KEYSIGHT
Evaluation apparatus name/model number: RF Impedance/Material Analyzer, 1.8 GHz 4291B
Measurement condition: measured at 1 MHz

(2) Dielectric strength (kV/mm)

Shape of evaluation sample: 100 mm × 100 mm, and the prepreg of the Comparative Example was measured with a thickness of 100 μm, while the other materials were measured with a thickness of 25 μm.
Manufacturer name: KEISOKU GIKEN Co., Ltd.
Evaluation apparatus name/ model number: Ultra-high voltage dielectric strength tester, Model 7472
Measurement condition: measured in conformity with IPC-TM-650 TM 2.5.7

The evaluation results for Examples 1 to 6 are as shown in Table 1 below.

[Table 1]

Comparison of Examples and Comparative Examples in Coil Structures

| | | | Comparative Example 1 | Comparative Example 2 | Example 1 | | Example 2 | | Example 3 | | Example 4 | Example 5 | Example 6 |
|---|---|---|---|---|---|---|---|---|---|---|---|---|---|
| Insulating Material | Member | | Core Material / Prepreg | Core Material / Prepreg | Polyimide | Material A | Polyimide | Material B | Polyimide | Material C | Material A | Material B | Material C |
| | Material name | | R 1766/R 1661 | R 1766/R 1661 | Single-sided board R-F770 | | Single-sided board R-F770 | | Single-sided board R-F770 | | | | |
| | Thickness of Insulating Material | μm | 100 | 100 | 25 | 25 | 25 | 25 | 25 | 25 | 50 | 50 | 50 |
| | Dielectric Constant (1 MHz) | | 4.7 | 4.7 | 3.2 | 3.1 | 3.2 | 2.65 | 3.2 | 2.7 | 3.1 | 2.65 | 2.7 |
| | Dielectric Strength | kV/mm | 64 | 64 | 276 | 229 | 276 | 308 | 276 | 333 | 229 | 308 | 333 |
| Laminated Coil (hypothetical example for comparison) | Structure | Coil pattern / Insulating material | Three layers of prepreg | One layer of prepreg | One layer of polyimide One layer of material A | | One layer of polyimide One layer of material B | | One layer of polyimide One layer of material C | | One layer of material A | One layer of material B | One layer of material C |
| | Distance Between Patterns | μm | 300 | 100 | 50 | | 50 | | 50 | | 50 | 50 | 50 |
| | Thickness of Pattern | μm | 25 | ← | ← | | ← | | ← | | ← | ← | ← |
| | Area of Pattern | mm2 | 80 | ← | ← | | ← | | ← | | ← | ← | ← |
| Effect Confirmation | Capacitance (1 MHz) | pF | 11.1 | 66.6 | 44.6 | | 41.1 | | 41.5 | | 43.9 | 37.5 | 38.2 |
| | Dielectric Strength | kV/mm | 192 | 64 | 505 | | 584 | | 609 | | 458 | 616 | 666 |
| | Low Leakage | | Unacceptable | Acceptable | Excellent | | Excellent | | Excellent | | Excellent | Excellent | Excellent |
| | Total Thickness (μm) | | 350 | 150 | 100 | | 100 | | 100 | | 100 | 100 | 100 |

The evaluation results for Examples 7 to 9 are as shown in Table 2 below.

[Table 2]

Comparison of Examples and Comparative Examples in Coil Structures

*Examples 7-9 are evaluations in a state where the PET material is removed and copper foil is attached (see reference below)

| | Member | Unit | Comparative Example 1 | Comparative Example 2 | Example 7 (Material D) | Example 7 (Material A) | Example 8 (Material B) | Example 8 (Material A) | Example 9 (Material B) | Example 9 (Material B) |
|---|---|---|---|---|---|---|---|---|---|---|
| Insulating Material | Material name | | Core Material: Prepreg R-1766/R-1661 | Core Material: Prepreg R-1766/R-1661 | Material D | Material A FBR-EZ75 | Material B | Material A | Material B | Material B |
| | Thickness of Insulating Material | μm | 100 | 100 | 25 | 25 | 25 | 25 | 25 | 25 |
| | Dielectric Constant (1 MHz) | | 4.7 | 4.7 | 3.1 | 3.1 | 2.65 | 3.1 | 2.65 | 2.65 |
| | Dielectric Strength | kV/mm | 64 | 64 | 229 | 229 | 308 | 229 | 308 | 308 |
| Laminated Coil (hypothetical example for comparison) | Structure | | Three layers of prepreg | One layer of prepreg | One layer of Material D / One layer of material A | | One layer of Material B / One layer of material A | | Two layers of Material B | |
| | Distance Between Patterns | μm | 300 | 100 | 50 | | 50 | | 50 | |
| | Thickness of Pattern | μm | 25 | ↓ | ↓ | | ↓ | | ↓ | |
| | Area of Pattern | mm2 | 80 | ↓ | ↓ | | ↓ | | ↓ | |
| Effect Confirmation | Capacitance (1MHz) | pF | 11.1 | 66.6 | 43.9 | | 40.5 | | 37.5 | |
| | Dielectric Strength | kV/mm | 192 | 64 | 458 | | 537 | | 616 | |
| | Low Leakage | | Unacceptable | Acceptable | Excellent | | Excellent | | Excellent | |
| | Total Thickness | (μm) | 350 | 150 | 100 | | 100 | | 100 | |

[13. Analysis of Examples]

(1) Capacitance

As shown by Comparative Examples 1 and 2, when the insulating material is the same, the capacitance is inversely proportional to the thickness of the insulating material, i.e., the distance between coil patterns formed on both sides of the insulating material. Therefore, in order to reduce the capacitance, it is necessary to increase the thickness of the insulating material; however, if it is done in such a manner, thinning of the magnetic device becomes difficult. In Examples 1 to 9 in which no prepreg is used, thinning is achieved so that the total thickness is 100 $\mu$m, and compared with Comparative Example 2, in which the insulating material thickness is 100 $\mu$m and the total thickness is 150 $\mu$m, the capacitance is greatly reduced to about two-thirds.

Even in comparison among the Examples, Examples 4 to 6, in which Materials A to C having a lower dielectric constant than polyimide were used alone, show reduced capacitance compared with Examples 1 to 3, in which polyimide and Materials A to C were laminated, despite having the same insulating material thickness. From this, in the magnetic device in which polyimide and any one of Materials A to C are laminated, as in Examples 1 to 3, it is considered that a reduction in capacitance is exhibited compared with the magnetic device using polyimide alone of the same thickness.

According to Examples 4 to 6, among the three materials, Materials B and C are superior in terms of capacitance, and in particular, the effect of Material B is remarkable. Even when combined with polyimide, Materials B and C are superior to Material A with respect to capacitance. This point is also confirmed by the results of Examples 7 to 9, in which two layers of Materials A to B were laminated, where Examples 8 and 9 containing Material B, and in particular Example 8 in which only Material B was laminated in two layers, show a significant reduction in capacitance.

(2) Dielectric Strength

Compared with the prepreg, polyimide and Materials A to C are greatly superior in dielectric strength characteristics as materials, and therefore, Examples 1 to 9 have far superior dielectric strength characteristics compared with Comparative Examples 1 and 2. Polyimide exhibits excellent dielectric strength characteristics even alone, but by combining it with Material B or Material C having higher dielectric strength characteristics, as shown in Examples 2 and 3, the magnetic device excellent in dielectric strength can be obtained. In particular, Material C showed the most excellent dielectric strength characteristics even compared with Materials A and B."

With respect to Material A, as shown in Examples 1 and 4, although it is lower than polyimide alone if only the dielectric strength characteristics are viewed, since it is superior in dielectric strength compared with the prepreg of Comparative Examples 1 and 2, and has lower capacitance than polyimide, it is more suitable than polyimide alone in applications where required dielectric strength and capacitance are considered.

Considering the above low capacitance and such excellent dielectric strength characteristics, it is apparent that the coil structures and multilayer circuit boards using Material B, and magnetic devices having such coil structures or multilayer circuit boards, exhibit extremely excellent properties in practical use.

(3) Low Leakage

Any of Examples 1 to 9 exhibits superior low leakage characteristics compared with Comparative Examples 1 and 2. In particular, although the distance between coil patterns is greatly reduced to 50 $\mu$m and the thickness of the insulating material is decreased, the reduction of leakage flux is advantageous for the use of various magnetic devices.

(4) Total Thickness

All of Examples 1 to 9 have the total thickness greatly reduced compared with Comparative Examples 1 and 2. In particular, even when the insulating material is thinned to a thickness approximately equal to that of the coil pattern, it is possible to achieve the desired capacitance, dielectric strength, and low leakage, and it is possible to realize miniaturization and thinning of the magnetic device.

[14. Other Embodiment]

The present disclosure is not limited to the above embodiment, and in the implementation stage, the components can be modified and embodied within a scope not departing from the gist thereof. In addition, various inventions can be formed by appropriately combining the plurality of components disclosed in the above embodiment. For example, some components among all the components shown in the embodiment may be deleted. Specifically, other embodiments as follows are also included.

(1) In the case of constituting the coil structure, the multilayer circuit board, and the magnetic device, as the insulating material for insulating between conductors, not only one kind but also, as shown in Examples 1 to 3, those in which different kinds of insulating materials are laminated can be used. Also, by using different kinds of insulating materials for each coil structure and laminating a plurality of such coil structures with different insulating materials, it is also possible to constitute a thicker coil structure, or to constitute the multilayer circuit board and the magnetic device

(2) The present disclosure is characterized by not using glass cloth, but not only glass cloth, it is also undesirable to use other base materials for resin impregnation that are impregnated with an insulating resin composition. That is, compared with the homogeneous layer of the insulating resin composition shown in this embodiment, many of the base materials for resin impregnation known conventionally are inferior in capacitance and dielectric strength characteristics, and if such base materials are present in the insulating material, the desired electrical and magnetic characteristics cannot be obtained.

(3) As the conductor, coil patterns formed by etching copper foil, coils made of copper plates, bus bars, and rectangular winding wires can be used. In the case of using copper foil, the coil pattern may be punched in advance and superposed on the surface of the insulating material that has been preliminarily dried or thermally cured, or an uncured insulating material may be applied or sprayed onto the punched coil pattern. In the case of a rigid conductor, it may be immersed in a liquid insulating material (dip treatment), and after being pulled up, preliminarily dried and thermally cured.

(4) With respect to Materials A to C, not limited to the compositions described in the Examples, as long as they are within the ranges of the respective materials shown in [1. Basic Configuration of Magnetic Device], superior effects can be expected compared with the polyimide described in the Examples.

REFERENCE SIGN

D...Magnetic device
C, C1, C2, C3...Coil structure
P, P1, P2, P3...Multilayer circuit board
S...Shield layer
1, 1a...Insulating material
10...Opening
21, 22, 23, 2a, 2b...Coil pattern
3, 3a, 3b...Copper foil
4...Core
41, 42...Leg portion
43, 44...Yoke portion
45...Central leg portion
5...Connector
6...Copper plate

**Claims**

1. A coil structure comprising:

   a plate-shaped conductor wound on a plane; and an insulating material insulating between the conductor, wherein the conductor and the insulating material being alternately laminated, and
   the insulating material is a cured product of an insulating resin composition not containing glass cloth.

2. The coil structure according to claim 1, wherein the insulating resin composition has a dielectric strength of 100 kV/mm or higher and a dielectric constant of 4.0 or lower.

3. The coil structure according to claim 1 or 2, wherein the insulating resin composition has adhesiveness.

4. The coil structure according to claim 3, wherein the insulating resin composition contains an epoxy resin.

5. The coil structure according to claim 3 or 4, wherein the insulating resin composition contains at least one of a polyamide resin, a polyimide resin, and a polyamide-imide resin.

6. The coil structure according to claim 4 or 5, wherein the insulating resin composition containing:

   (a1) liquid epoxy resin,
   (a2) solid epoxy resin having a softening point of 125 °C or less,

(b) an aromatic diamine compound having a benzoate group and having a polymethylene group in its main chain,
(c) a solvent-soluble polyimide resin having a Tg of 200 °C or more and a wight-average molecular weight (Mw) of 50,000 or less, and
(D) a phenoxy resin having a Tg of 130 °C or more,

wherein when a total amount of the (a1) liquid epoxy resin, the (a2) solid epoxy resin, and the (b) aromatic diamine compound is 100 parts by weight, a total amount of the (c) solvent-soluble polyimide resin and the (d) phenoxy resin is 15 parts by weight or more and 150 parts by weight or less.

7.  The coil structure according to any one of claims 3 to 6, wherein the insulating resin composition is a polyimide derived from (A) an acid dianhydride and (B) a diamine;

    wherein the (A) acid dianhydride includes (A1) an acid anhydride having an ester linkage,
    wherein the (B) diamine contains 0.3 mol or more of (B1) a dimer diamine when the total number of moles of the diamine is 1.0.

8.  The coil structure according to any one of claims 3 to 6, wherein the insulating resin composition is a polyimide derived from (A) an acid dianhydride and (B) a diamine;
    wherein the (B) diamine contains (B1) diamine having a fluorene skeleton and a (B2) dimer diamine.

9.  The coil structure according to claim 1, formed by laminating a resin-coated copper foil wherein the insulating resin composition is formed on one surface of a copper foil.

10. A multilayer circuit board comprising the coil structure according to any one of claims 1 to 9.

11. The multilayer circuit board according to claim 10, wherein a shield layer is provided on an outermost layer or an intermediate layer.

12. A magnetic device comprising the multilayer circuit board according to claim 10 or 11 and a core attached thereon.

13. A magnetic device comprising a plurality of the multilayer circuit boards according to claim 10 or claim 11 laminated, and a core mounted thereon.

14. A magnetic device comprising a plurality of laminations of the coil structure according to claim 1 and the multilayer circuit board according to claim 10 or claim 11, and a core mounted thereon.

15. The magnetic device according to any one of claims 12 to 14, wherein the operating frequency is 500 kHz to 1 MHz.

16. A resin-coated copper foil for a coil structure,

    wherein the resin-coated copper foil has an insulating resin composition formed on one surface of a copper foil, a resin layer consisting of the insulating resin composition in a semi-cured state or an insulating resin composition different from the insulating resin composition is formed on the surface of the insulating resin composition of the resin-coated copper foil, and
    a protective film is laminated on the surface of the semi-cured resin layer.

17. A resin-coated copper foil for a coil structure,
    wherein a resin layer consisting of an insulating resin composition in a semi-cured state is formed on one surface of a copper foil, and a protective film is laminated on the surface of the semi-cured resin layer.

18. A method for manufacturing a coil structure, wherein the resin-coated copper foil according to claim 16 or claim 17 is laminated in a state in which the protective film is removed, such that the semi-cured resin layer and the copper foil are in contact with each other.

Fig. 1A

Fig. 1B

Fig. 1C

*Fig. 2A*

*Fig. 2B*

*Fig. 2C*

*Fig. 2D*

*Fig. 2E*

*Fig. 2F*

*Fig. 3A*

*Fig. 3B*

*Fig. 4A*

*Fig. 4B*

*Fig. 5A*

*Fig. 5B*

*Fig. 6A*

*Fig. 6B*

*Fig. 7A*

*Fig. 7B*

*Fig. 8A*

*Fig. 8B*

Cu

A1

A2

PEN

A3

S

*Fig. 9*

Cu

B
Cu
B1

A
B
Cu
B2

PEN
A
B
Cu
B3

Cu
A
B
Cu
S

*Fig. 10*

*Fig. 11*

## INTERNATIONAL SEARCH REPORT

| International application No. |
| --- |
| **PCT/JP2024/013098** |

| A. | CLASSIFICATION OF SUBJECT MATTER |
| --- | --- |

*H01F 27/32*(2006.01)i; *H01F 17/00*(2006.01)i; *H01F 17/04*(2006.01)i; *H05K 1/16*(2006.01)i
FI:   H01F27/32 130; H01F17/04 F; H01F17/00 D; H05K1/16 B

According to International Patent Classification (IPC) or to both national classification and IPC

| B. | FIELDS SEARCHED |
| --- | --- |

Minimum documentation searched (classification system followed by classification symbols)

    H01F27/32; H01F17/00; H01F17/04; H05K1/16

Documentation searched other than minimum documentation to the extent that such documents are included in the fields searched

    Published examined utility model applications of Japan 1922-1996
    Published unexamined utility model applications of Japan 1971-2024
    Registered utility model specifications of Japan 1996-2024
    Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2004-200468 A (DENSO CORPORATION) 15 July 2004 (2004-07-15) paragraphs [0001]-[0024], fig. 1-12 | 1, 3, 9-15 |
| Y | | 2-5, 7-18 |
| A | | 6 |
| Y | JP 2020-94213 A (SEKISUI CHEMICAL CO., LTD.) 18 June 2020 (2020-06-18) paragraphs [0001]-[0275], fig. 1 | 2-5, 7-15 |
| A | | 6 |
| Y | JP 2018-168370 A (ARAKAWA CHEMICAL INDUSTRIES, LTD.) 01 November 2018 (2018-11-01) paragraphs [0001]-[0180] | 16-18 |

☐ Further documents are listed in the continuation of Box C.     ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **04 June 2024** | **18 June 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/013098**

| Patent document cited in search report | | | Publication date (day/month/year) | Patent family member(s) | | | Publication date (day/month/year) |
|---|---|---|---|---|---|---|---|
| JP | 2004-200468 | A | 15 July 2004 | (Family: none) | | | |
| JP | 2020-94213 | A | 18 June 2020 | (Family: none) | | | |
| JP | 2018-168370 | A | 01 November 2018 | JP | 2022-33144 | A | |
| | | | | CN | 108690193 | A | |
| | | | | KR | 10-2018-0110632 | A | |
| | | | | TW | 201840650 | A | |
| | | | | KR | 10-2022-0050860 | A | |
| | | | | TW | 202219124 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H09326316 A